# EUROPEAN PATENT APPLICATION

(11) **EP 4 531 140 A1**
(43) Date of publication of application: **02.04.2025**
(21) Application number: 23841740.6
(22) Date of filing: 23.02.2023
(51) Int. Cl.: H01M 4/525

(54) **COMPOSITE COATING AGENT FOR POSITIVE ELECTRODE MATERIAL, HIGH-NICKEL SINGLE-CRYSTAL POSITIVE ELECTRODE MATERIAL, AND BATTERY**

(30) Priority: 22.07.2022 CN 202210866765
(71) Applicant: Ningbo Ronbay New Energy Technology Co., Ltd., Yuyao Ningbo, Zhejiang 315402 (CN)
(72) Inventor: LI, Bingbing, Ningbo, Zhejiang 315402 (CN); QU, Zhenhao, Ningbo, Zhejiang 315402 (CN); LIU, Zhiyuan, Ningbo, Zhejiang 315402 (CN); DONG, Peipei, Ningbo, Zhejiang 315402 (CN); YU, Jian, Ningbo, Zhejiang 315402 (CN)
(74) Representative: Bandpay & Greuter
(86) International application number: PCT/CN2023/077793
(87) International publication number: WO 2024/016662

(57) **Abstract**

The present invention provides a composite coating agent for a positive electrode material, including a first coating agent, a second coating agent and a third coating agent. The first coating agent is a hydroxide, an oxide, a sulfide, a nitrate or a carbonate of a first coating element, the second coating agent is a hydroxide, an oxide, a sulfide, a nitrate or a carbonate of a second coating element, and the third coating agent is a hydroxide, an oxide, a sulfide, a nitrate or a carbonate of a third coating element. In the composite coating agent disclosed by the present invention, different elements are compounded on the surface of the positive electrode material so as to reduce excessive precipitation of Li in the positive electrode material, lower the formation of residual alkali, mitigate the generation of micro-cracks on the surface of the positive electrode material, and protect the positive electrode material from direct contact with the electrolyte. The residual lithium of the coated positive electrode material and gas production of the soft pack battery thereof will be reduced, improving the safety and stability of the material, and the thermal stability and electrolyte protection of the generated oxide of coating element improve the cycling stability of the material.

## Description

This application claims priority to Chinese Patent Application No. 202210866765.8, filed with the China National Intellectual Property Administration (CNIPA) on July 22, 2022, entitled with "COMPOSITE COATING AGENT FOR POSITIVE ELECTRODE MATERIAL, HIGH-NICKEL SINGLE-CRYSTAL POSITIVE ELECTRODE MATERIAL, AND BATTERY", which is hereby incorporated by reference in its entirety.

### TECHNICAL FIELD

The invention relates to the technical field of battery materials, in particular to a composite coating agent for positive electrode material, a high-nickel single-crystal positive electrode material and a battery.

### BACKGROUND

The research and application of positive electrode materials for lithium-ion batteries are very wide. Prior art CN109713262A discloses a method for preparing a cobalt oxide coated positive electrode material, which relates to a method for preparing a cobalt oxide coated positive electrode material and belongs to the technical field of battery positive electrode materials. The problem to be solved by this prior art is how to achieve low sintering temperature and low coating amount with high rate performance, and the method includes placing a cobalt source and a high-nickel positive electrode material into a container, and then stirring and mixing at a rotational speed of ≤ 700 rpm to obtain the corresponding mixture; under an atmosphere of air or oxygen, subjecting the mixture to a low-temperature solid-phase sintering treatment at a temperature of 250°C-550°C to obtain the corresponding cobalt oxide coated positive electrode material, where the coating amount of cobalt oxide is 0.1wt%-1.0wt% of the mass of the positive electrode material. It can effectively realize the effect of low cobalt oxide coating, and realize the rate and cycle performance of the material under high pressure conditions. However, the single cobalt source coating in this document only serves as an isolation layer to alleviate the interfacial reaction between the material and the electrolyte, reduce the surface impurities of the material, and improve the transport of lithium ions and reduce polarization; however, the cobalt coated after annealing not only produces amorphous cobalt oxide and a small amount of cobalt oxide on the surface of the material, but also produces poor conductor tricobalt tetraoxide, which not only impedes the contact between the charge and electrolyte and the positive electrode, impedes the charge transport and reduces the conductivity of the material, but also causes the inhomogeneity and instability of the coating layer, and there are no measures to solve the Li/Ni mixed arrangement inside the high-nickel ternary positive electrode and alleviate the internal and external micro-cracks.

Prior art CN112194196A discloses a composite coating agent for an ultra-high-nickel single-crystal ternary positive electrode material, a preparation method and use thereof, discloses a composite coating agent for an ultra-high-nickel single-crystal ternary positive electrode material, a preparation method and use thereof, belonging to the technical field of lithium ion power batteries for new energy vehicles. A composite coating agent for ultra-high-nickel single-crystal ternary positive electrode material comprises at least one of metal and/or non-metal oxide, ammonium compound and solvent; and is prepared by at least one process of ball milling, air flow attrition, calcination, wet mixing and spray drying. The prepared composite coating agent forms a uniform coating layer on the surface of the single-crystal material by coating and calcination, and at the same time, the residual alkali level on the surface can be reduced, and the cycle performance and safety performance of the material can be improved. However, this document uses a wet process and adds a wet coating liquid. On the one hand, since the residual lithium on the surface of the material is directly washed away by the wet process, which does not improve the Li/Ni mixing and Li transmission channels inside the material; and over-washing or insufficient washing, and inhomogeneous washing present in the wet process cause great damage to the positive electrode material on the surface of the material, resulting in problems such as inhomogeneous material surface and decrease of the cycle rate performance. On the other hand, the use of wet coating solution is prone to the phenomena that the coating agent falls during the charge and discharge process of the positive electrode material, and the electrolyte is in contact with the surface of the positive electrode due to crack of the coating agent, which results in the particles of the positive electrode material being more prone to cracks and then rupture during the charging/discharging cycle of the positive electrode material. It will accelerate the corrosion of the positive electrode active material by the electrolyte, resulting in severe capacity reduction and poor cycle performance of the lithium-ion battery; and the preparation method has complicated process and high cost, and is not suitable for large-scale industrialization.

Therefore, it is necessary to provide a positive electrode material with high capacity and good cycle stability.

### SUMMARY

In view of this, the technical problem to be solved by the present invention is to provide a high-nickel single-crystal positive electrode material, and the positive electrode material provided by the present invention has high capacity and good cycle stability.

The invention provides a composite coating agent for a positive electrode material, including a first coating agent, a second coating agent and a third coating agent; the first coating agent is a hydroxide, an oxide, a sulfide, a nitrate, or a carbonate of a first coating element; the second coating agent is a hydroxide, an oxide, a sulfide, a nitrate, or a carbonate of a second coating element; the third coating agent is a hydroxide, an oxide, a sulfide, a nitrate, or a carbonate of a third coating element;
where the first coating element includes one or more of Ni, Mn, Co, and B; the second coating element includes one or more of Mg, Al, Nb, W, and Mo; the third coating element includes one or more of Ti, Cr, Zr, Y, and Sr.

Preferably, the molar ratio of the first coating element, the second coating element, and the third coating element is 1-15: 0.1-18: 0-12.

Preferably, the first coating agent is at least one of NiMnCo(OH)₂, NiMnCoCO₃, Co(OH)₂, MnCO₃, CoCO₃, H₃BO₃, B(NO₃)₃, CoOOH, or Mn(OH)₂.

Preferably, the second coating agent is at least one of MgO, MgCO₃, Mg(OH)₂, Al₂O₃, Al(OH)₃, MoO₃, Mo(OH)₃, WO₃, Nb(OH)₅, or Nb₂O₅; and
the third coating agent is at least one of TiO, Cr(OH)₂, ZrO₂, C₂O₅Zr, Y₂O₃, or Sr(OH)₂.

The invention provides a coating layer prepared from the coating agent mentioned in any of the above-described technical solutions.

The present invention provides a high-nickel single-crystal positive electrode material, including a positive electrode material substrate and the coating layer of the above technical solution arranged on the surface of the positive electrode material substrate.

Preferably, the structural formula of the positive electrode material substrate is LiₓNiₐM_{b}N_{c}O₂, where 0.8 ≤ x ≤ 1.05, 0.8 ≤ a ≤ 0.98, b = 1-a-c, 0 ≤ c < 0.2; M is selected from at least one of Mn, Co, Al, Mg, or Fe; N is a doping element selected from at least one of Ti, Ta, K, Sb, Na, B, Sc, V, Sn, Y, Zr, Mg, Cr, Nb, W, or Mo.

Preferably, the molar fraction of the coating element in the coating layer to the positive electrode material substrate is 0.0001-8%.

Preferably, the coating layer is composed of a lithium-containing coating element oxide and a lithium-free coating element oxide.

Preferably, in the coating layer, the ratio of the molar amount of a coating element contained in the lithium-containing coating element oxide to the total amount of the coating element is 50%-89%.

Preferably, in the lithium-containing coating element oxide, the molar ratio of the first coating element, the second coating element and the third coating element is 29-100: 0-71: 0-66.

The invention provides a preparing method of a high-nickel single-crystal positive electrode material, which includes the following steps:
A) mixing a ternary precursor and lithium hydroxide monohydrate, adding a doping agent, and calcining in the presence of a protective gas to obtain a calcined material;
B) crushing the calcined material, removing iron and sieving to obtain a positive electrode material substrate;
C) mixing the positive electrode material substrate with a coating agent, calcining again in the presence of the protective gas, then crushing, sieving and removing iron to obtain the high-nickel single-crystal positive electrode material.

Preferably, the doping agent is selected from at least one of TiO, Ti₂O₃, Sc₂O₃, MgO, K₂CO₃, V₂O₅, Cr₂O₃, Sb₂O₃, Ta₂O₅, Y₂O₃, Zr₂O₃, ZrO₂, NaBO₂, WO₃, MoO₃, Nb₂O₅, and the like;
the calcining in the step A) specifically includes: raising a temperature to 190-420°C at a heating rate of 1-10°C·min⁻¹ and maintaining for 3.5-10.5h, then raising the temperature to 690-920°C at 2-4°C·min⁻¹ and maintaining for 8-11h, and then cooling to room temperature at 2-3°C·min⁻¹;
the calcining in the step C) specifically includes raising a temperature to 500-810°C at a heating rate of 3-10°C/min and maintaining for 9-11h.

The present invention provides a lithium-ion battery, including the high-nickel single-crystal positive electrode material according to any one of the above technical solutions or a high-nickel single-crystal positive electrode material prepared by the preparing method according to any one of the above technical solutions.

Compared with the prior art, the present invention provides a composite coating agent for a positive electrode material, including a first coating agent, a second coating agent and a third coating agent; the first coating agent is a hydroxide, an oxide, a sulfide, a nitrate, or a carbonate of a first coating element, the second coating agent is a hydroxide, an oxide, a sulfide, a nitrate or a carbonate of a second coating element, the third coating agent is a hydroxide, an oxide, a sulfide, a nitrate, or a carbonate of a third coating element; where the first coating element includes one or more of Ni, Mn, Co, and B; the second coating element includes one or more of Mg, Al, Nb, W, and Mo; the third coating element includes one or more of Ti, Cr, Zr, Y, and Sr. The composite coating agent of the invention adopts different elements to be compounded on the surface of the positive electrode material, which reduces the excessive precipitation of Li in the positive electrode material, lowers the formation of residual alkali, alleviates the generation of micro-cracks on the surface of the positive electrode material, and protects the positive electrode material from direct contact with the electrolyte. Therefore, the residual lithium of the positive electrode material coated by the coating agent of the invention and the gas production rate of the soft pack battery are correspondingly reduced, thereby improving the safety and stability of the positive electrode material involved in the invention; moreover, the special lithium-containing coating element oxide contained in the coating layer of the invention has partial energy storage function, which has a certain improvement effect on the capacity and stability of the material, at the same time, the thermal stability and protective effect on the electrolyte brought by the generated coating element oxide enhance the material's cycling stability without damaging the material.

### DESCRIPTION OF EMBODIMENTS

The invention provides a composite coating agent for a positive electrode material, a high-nickel single-crystal positive electrode material and a battery, which can be realized by those skilled in the art by referencing the contents herein and improving the process parameters appropriately. It is particularly noted that all similar substitutions and alterations will be apparent to one skilled in the art, and that they fall within the scope of protection of the present invention. The methods and application of the present invention have been described with reference to the preferred embodiments, and it will be apparent to the related person that the techniques of the present invention will be realized and applied by making modifications or suitable alterations and combinations of the methods and applications herein without departing from the content, spirit and scope of the present invention.

The invention provides a composite coating agent for a positive electrode material, including a first coating agent, a second coating agent and a third coating agent; the first coating agent is a hydroxide, an oxide, a sulfide, a nitrate, or a carbonate of a first coating element, the second coating agent is a hydroxide, an oxide, a sulfide, a nitrate or a carbonate of a second coating element, and the third coating agent is a hydroxide, an oxide, a sulfide, a nitrate, or a carbonate of a third coating element;
where the first coating element includes one or more of Ni, Mn, Co, and B; the second coating element includes one or more of Mg, Al, Nb, W, and Mo; the third coating element includes one or more of Ti, Cr, Zr, Y, and Sr.

The composite coating agent for a positive electrode material according to the present invention includes a first coating agent.

According to the present invention, the first coating agent is a hydroxide, oxide, sulfide, nitrate or carbonate of a first coating element; the first coating element includes one or more of Ni, Mn, Co, and B.

In a part of preferred embodiments of the present invention, the first coating agent is at least one of NiMnCo(OH)₂, NiMnCoCO₃, Co(OH)₂, MnCO₃, CoCO₃, H₃BO₃, B(NO₃)₃, CoOOH, or Mn(OH)₂.

The composite coating agent for a positive electrode material according to the present invention includes a second coating agent.

The second coating agent according to the present invention is a hydroxide, an oxide, a sulfide, a nitrate or a carbonate of a second coating element; the second coating element includes one or more of Mg, Al, Nb, W, and Mo.

In a part of preferred embodiments of the present invention, the second coating agent is at least one of MgO, MgCO₃, Mg(OH)₂, Al₂O₃, Al(OH)₃, MoO₃, Mo(OH)₃, WO₃, Nb(OH)₅, or Nb₂O₅.

The composite coating agent for a positive electrode material according to the present invention includes a third coating agent.

The third coating agent according to the present invention is a hydroxide, an oxide, a sulfide, a nitrate or a carbonate of a third coating element; the third coating element includes one or more of Ti, Cr, Zr, Y, and Sr.

In a part of preferred embodiments of the present invention, the third coating agent is at least one of CrO₃, TiO, Cr(OH)₂, ZrO₂, C₂O₅Zr, Y₂O₃, and Sr(OH)₂.

The composite coating agent of the present invention contains different groups of element species. The combination and proportion of these elements can be used as a coating layer to reduce the excessive precipitation of Li and the formation of residual alkali in the positive electrode material, generate a Li-containing compound with energy storage effects, and alleviate the occurrence of micro-cracks on the surface of the positive electrode material.

The present invention provides a coating layer prepared from the coating agent according to any one of the above technical solutions.

Through the reaction between the first coating agent and Li excessively precipitated in the charging and discharging process of the positive electrode material, the invention not only reduces the loss of Li in the material, but also generates the lithium-containing coating element oxide with energy storage function, which prevents the Li excessively precipitated and H₂O and CO₂ from generating Li₂CO₃ under certain conditions, thereby reducing the gas production of the battery containing high-nickel ternary positive electrode material. On the one hand, the element in the second coating agent can react with the electrolyte to generate a solid superacid, which can remove impurities on the surface of the positive electrode material and improve the charge transfer in the SEI film on the surface of the positive electrode material and the ion transport in the electrolyte, and inhibit the increase in surface impedance caused by it; on the other hand, the high thermal stability of the second coating agent can inhibit the generation of oxygen and strengthen the electrolyte, ultimately reducing the loss of electrochemical capacity of the ternary positive electrode material. After coating, the elements in the third coating agent will enter into the layer structure of the positive electrode material via processing and form chemical bonds with the oxygen atoms in the lattice to improve the stability of the material, expanding the Li transport channel, reducing the Li/Ni mixing, and effectively alleviating the occurrence of internal strain and structural degradation.

The invention provides a high-nickel single-crystal positive electrode material, including a positive electrode material substrate and a coating layer provided on the surface of the positive electrode material substrate and described according to the above technical solutions.

The structural formula of the positive electrode material substrate of the present invention is LiₓNiₐM_{b}N_{c}O₂, where 0.8 ≤ x ≤ 1. 05, 0.8 ≤ a ≤ 0. 98, b = 1-a-c, and 0 ≤ c < 0.2; M is selected from at least one of Mn, Co, Al, Mg, or Fe; N is a doping element selected from at least one of Ti, Ta, K, Sb, Na, B, Sc, V, Sn, Y, Zr, Mg, CrNb, W, or Mo.

The structural formula of the high-nickel single-crystal positive electrode material of the invention is LiₓNiₐM_{b}N_{c}O₂/K. K is a coating layer.

The coating layer is prepared from the coating agent described in any one of the above technical solutions; where part of the coating agent reacts with lithium to obtain a lithium-containing coating element oxide.

Therefore, the coating layer of the present invention is composed of a lithium-containing coating element oxide and a lithium-free coating element oxide.

The first coating element is denoted as K1; the second coating element is denoted as K2; and the third coating element is denoted as K3.

Further preferably, K1:K2:K3=1-15:0.1-18:0-12; K1:K2:K3=1-9:0.7-4:0-1.4, K1:K2:K3=5-8:0.8-1.2:0-0.2, K1:K2:K3=2-10:1-10:0-1, K1:K2:K3=4-8:0.1-0.8:0-0.5, K1:K2:K3=10:1-2:1, K1:K2:K3=6:1-2:0-1, K1:K2:K3=6-10:1-2:0-1, K1:K2:K3=6:1:0, K1:K2:K3=6-8:0.5-2:0-2, K1:K2:K3=6-8:1-4.5:2-3.5, K1:K2:K3=3:2:1, K1:K2:K3=6-8.5:1:0.5-1, K1:K2:K3=6:1-2:0-0.5, K1:K2:K3=0.2-1.2:1-2:0-2, K1:K2:K3=4:1:0.5, K1:K2:K3=8:1.5:0, K1:K2:K3=6:0.7:0.6, K1:K2:K3=7:1:0.9, K1:K2:K3=0.4:1:1.4.

The molar fraction of the coating element in the coating layer of the present invention accounts for preferably 0.0001 to 8%, more preferably 0.1 to 8%, most preferably 0.19-8% of the positive electrode material substrate.

In a part of embodiments of the present invention, the molar fraction of the coating element in the coating layer accounts for 0.016-5.6% of the positive electrode material substrate; further, it may also be 0.024-0.92%; further, it may also be 0.036-0.78%, further, it may also be 0.052-2.7%, further, it may also be 0.078-6.2%, further, it may also be 4.5-7.6%, further, it may also be 3.8-4.8%, and further, it may also be 3.5-3.9%.

The existing forms of the elements K1, K2 and K3 of the invention are lithium-containing coating element oxide and a small amount of lithium-free coating element oxide, and the lithium-containing coating element oxide is positioned on the surface of the positive electrode material substrate, which is beneficial to energy storage performance; and the lithium-free coating element oxide is positioned on the outside of the lithium-containing coating element oxide, which is beneficial to gas production performance.

Further, the coating layer according to the present invention is composed of a lithium-containing coating element oxide and a lithium-free coating element oxide.

The lithium-containing coating element oxide according to the present invention is an oxide formed of Li and a coating element in a positive electrode material.

The ratio of the molar amount of the coating element contained in the lithium-containing coating element oxide to the total amount of the coating element is preferably 50-89%, more preferably 51-83%; the ratio of the molar amount of the coating element contained in the lithium-free coating element oxide to the total amount of the coating element is preferably 11-50%.

In the lithium-containing coating element oxide, the first coating element is denoted as m1; the second coating element is denoted as m2 and the third coating element is denoted as m3.

Where, in the lithium-containing coating element oxide, the ml element accounts for 29-100% of the molar fraction of the coating element contained in the lithium-containing coating element oxide, the m2 element accounts for 0-71% of the molar fraction of the coating element contained in the lithium-containing coating element oxide, and the m3 element accounts for 0-66% of the molar fraction of the coating element contained in the lithium-containing coating element oxide.

Further, in the lithium-containing coating element oxide, m1: m2: m3 = 29-100: 0-71: 0-66; preferably, m1: m2: m3 = 30-90: 2-30: 0-15.

In the invention, since the positive electrode material will easily undergo phase change in its near surface area during its contact with the electrolyte, its original layered structure is transformed into a spinel phase and a rock salt phase and the Li ion conductivity of these two structures is low, which reduces the transmission of Li ions, and increases the polarization of the positive electrode material; and because the coating layer needs to provide transmission channels for ions and electrons, its unique leakiness nature will cause part of the electrolyte to come into contact with the surface of the material, resulting in phase transformation on the surface of the material, and capacity attenuation of the positive electrode material.

The present invention solves the above problems by forming chemical bonds between the elements doped in the positive electrode material and the oxygen atoms in the crystal lattice to improve the stability of the material, which expands the transport channel of Li, reduces the Li/Ni mixing, reduces the formation of the NiO rock salt phase on the surface of the positive electrode material, and effectively mitigates the occurrence of internal strains and structural degradation.

In the present invention, the doped element and the lithium-containing coating element oxide and the lithium-free coating element oxide formed on the surface of the positive electrode material can stabilize the internal structure of the material, protect the surface of the material from being eroded by the electrolyte and provide a part of the capacity. Therefore, generally, the doping and coating measures in the invention largely improve the cycle performance and thermal stability of the single-crystal material; and at the same time, the residual alkali and gas production levels are lower than those of ordinary single coating modification, and the overall capacity of the material can be improved, thereby obtaining a high-nickel single-crystal ternary positive electrode material with good overall performance.

The invention provides a method for preparing a high-nickel single-crystal positive electrode material, which includes the following steps:
A) mixing a ternary precursor and lithium hydroxide monohydrate, adding a doping agent, and calcining in the presence of protective gas to obtain a calcined material;
B) crushing the calcined material, removing iron and sieving to obtain a positive electrode material substrate;
C) mixing the positive electrode material substrate with a coating agent, calcining again in the presence of protective gas, then crushing, sieving and performing iron removal to obtain the high-nickel single-crystal positive electrode material.

In the method for preparing the high-nickel single-crystal positive electrode material provided by the invention, a ternary precursor and lithium hydroxide monohydrate are firstly mixed.

In the invention, preferably, the ternary precursor is specifically Ni_{0.8}Co_{0.12}Mn_{0.08}(OH)₂, Ni_{0.8}Co_{0.1}Mn_{0.1}(OH)₂, Ni_{0.8}Co_{0.15}Al_{0.05}(OH)₂, Ni_{0.82}Co_{0.1}Mn_{0.08}(OH)₂, Ni_{0.83}Co_{0.12}Mn_{0.05}(OH)₂, Ni_{0.85}Co_{0.05}Mn_{0.1}(OH)₂, Ni_{0.85}Co_{0.1}Mn_{0.05}(OH)₂, Ni_{0.9}Co_{0.05}Mn_{0.05}(OH)₂, Ni_{0.96}Co_{0.02}Mn_{0.02}(OH)₂, Ni_{0.98}Co_{0.01}Mn_{0.01}(OH)₂.

Where, the molar ratio of the lithium to the metal in the ternary precursor is 0.8-1.05: 1; in the present invention, there is no limitation on the specific mixing mode, as long as the mixing mode is well known to those skilled in the art.

After mixing, the doping agent is added and calcined in the presence of the protective gas to obtain calcined material;
the doping agent of the present invention is selected from the doping agent is selected from at least one of TiO, Ti₂O₃, Sc₂O₃, MgO, K₂CO₃, V₂O₅, Cr₂O₃, Sb₂O₃, Ta₂O₅, Y₂O₃, Zr₂O₃, ZrO₂, NaBO₂, WO₃, MoO₃, Nb₂O₅, and the like;
the addition amount of the doping agent in the present invention is preferably 0-0. 19wt%, 0.0001-0. 15wt%, 0.00015-0.09wt%, 0.0002-0.078wt%, and 0.0032-0.054wt%.

Further, the molar fraction of the doping element in the positive electrode material substrate is preferably 0.28-0.76%; more preferably 0.32-0.64%; most preferably 0.39-0.64%.

In the present invention, there is no limitation on the protective atmosphere described, as long as the protective gas is well known to those skilled in the art. The protective gas includes but is not limited to nitrogen, helium, argon, and the like.

Specifically, the calcining is specifically as follows: raising the temperature to 190-420°C at a heating rate of 1-10°C·min⁻¹ and holding for 3.5-10.5 h; then raising the temperature to 690-920°C at 2-4°C·min⁻¹ and holding for 8-11h; then cooling to room temperature at 2-3°C·min⁻¹.

The calcined material is crushed, subjected to iron removal and sieved to obtain a positive electrode material matrix.

In the present invention, there is no limitation on the specific operations of the crushing, iron removal and sieving, which are known to those skilled in the art.

The positive electrode material substrate is mixed with a coating agent and calcined again in the presence of a protective gas.

The ratio of the positive electrode material substrate and the coating agent according to the present invention has been clearly described above, and will not be repeated herein.

Where, the calcination specifically comprises the following steps: raising the temperature to 500-810°C at a rate of 3-10°C/min and holding for 9-11 hours.

Then, the calcined material is subjected to crushing, sieving and iron removal. In the present invention, there is no limitation on the specific operations of the crushing, iron removal and sieving, which are known to those skilled in the art.

The present invention provides a lithium-ion battery including a high-nickel single-crystal positive electrode material described in any one of the above technical solutions or a high-nickel single-crystal positive electrode material prepared by the preparation method described in any one of the above technical solutions.

The present invention adopts a dry coating process. Compared with the wet process, where the residual lithium on the surface of the material is washed off, the Li/Ni mixing and Li transmission channels inside the material and so on are not improved, and the particular over-washing or insufficient washing and uneven washing existing in the wet process cause extreme damage to the cathode material on the surface of the material, resulting in the uneven surface of the material and the reduction of the cycle rate capability, and other problems, the present invention only needs to directly coat the doped positive electrode material, which fundamentally solves the problem of the generation of residual alkali without damaging the material, and can obtain ternary materials with good capacity, cycling and rate capability, thus improving the residual alkali level.

The coating agent in the present invention is uniformly coated on the surface of the material, forming dense small particles, isolating the electrolyte from contact with the positive electrode material, and enhancing the cycle life of the material. If the mass ratio of the composite coating agent and the high-nickel ternary material in the present invention is less than 0.0001%, the coating agent is insufficient to completely coat the surface of the material, and the electrolyte comes into contact with the positive electrode material, resulting in failure of the coating action; and if the mass ratio of the composite coating agent and the high-nickel ternary material is greater than 8%, the coating layer is too thick and uneven, causing the migration of lithium ions to be hindered, and making the rate and cycle behavior decrease.

The coating layer of the present invention provides part of the capacitance while protecting the cathode material from contacting with the electrolyte, thereby realizing the improvement of the capacity and stability of the positive electrode material; and improves the production of lithium residue on the surface of the positive electrode material and the gas production of the final soft-packed battery, which improves the safety and stability performance of the material. Moreover, the dry process of the invention reduces a large amount of energy consumption and equipment process loss in the production process, so it has the advantage of promoting mass production.

In order to further illustrate the present invention, a composite coating agent for a positive electrode material, a high-nickel single-crystal positive electrode material, and a battery provided by the present invention will be described in detail below with reference to examples.

### Example 1

The composite coating agent in this example was composed of H₃BO₃ and Mo(OH)₃, where the molar ratio of the first coating element (B), the second coating element (Mo) and the third coating element was 6: 1: 0, and H₃BO₃ and Mo(OH)₃ were evenly mixed to give a mixture which was denoted as a composite coating agent 1.
S1: mixing a Ni_{0.85}Co_{0.1}Mn_{0.05}(OH)₂ ternary precursor with battery-grade lithium hydroxide monohydrate at the molar ratio of lithium element to metal of 1.03:1, and adding a doping agent ZrO₂, the molar ratio of the doping agent being 0.39%; and then raising the temperature to 300°C under oxygen atmosphere at a heating rate of 2°C·min⁻¹ and maintaining for 4h; then raising the temperature to 700°C at 2°C·min⁻¹ and maintaining for 10h; and then cooling to room temperature at 3°C·min⁻¹ to obtain a primary calcined material;
S2: coarsely crushing and finely crushing the primary calcined material to obtain a crushed material;
S3: sieving the crushed material and removing iron to obtain a primary sintered positive electrode material substrate;
S4: uniformly mixing the obtained positive electrode material substrate with the composite coating agent 1 to give a mixture, where the molar ratio of the coating agent is 0.7%, then placing the mixture in an atmosphere furnace to heat up to 650°C/min at a rate of 5°C/min, maintaining for 10h, crushing, sieving, and removing iron to obtain the high-nickel single-crystal ternary positive electrode material coated with the composite coating agent 1.

### Example 2

The composite coating agent in this example was composed of CoCO₃ and MgO, where the molar ratio of the first coating element (Co), the second coating element (Mg) and the third coating element was 1: 1: 0, the molar ratio of the coating agent was1.6%, and the ternary precursor was Ni_{0.83}Co_{0.12}Mn_{0.05}(OH)₂, the doping agent was TiO and the molar ratio of the doping agent was 0.4%, and the rest of the steps were the same as in example 1, the details being as shown in Table 1.

### Example 3

The composite coating agent in this example was composed of CoOOH, Al₂O₃, and CrO₃, where the molar ratio of the first coating element (Co), the second coating element (AL) and the third coating element (Cr) was 6:0.7:0.6, the molar ratio of the coating agent was 3.71%, and the ternary precursor was Ni_{0.82}Co_{0.1}Mn_{0.08}(OH)₂, the doping agent was Y₂O₃ and the molar ratio of the doping agent was 0.52%, and the rest of the steps were the same as in example 1, the details being as shown in Table 1.

### Example 4

The composite coating agent in this example was composed of Co(OH)₂ and MoO₃, where the molar ratio of the first coating element (Co), the second coating element (Mo) and the third coating element was 5:0.7:0, the molar ratio of the coating agent was 2.66%, and the ternary precursor was Ni_{0.85}Co_{0.05}Mn_{0.1}(OH)₂, the doping agent was MgO and Ta₂O₅ and the molar ratio of the doping agent was 0.46%, and the rest of the steps were the same as in example 1, the details being as shown in Table 1.

### Example 5

The composite coating agent in this example was composed of Mn(OH)₂ and Nb₂O₅, where the molar ratio of the first coating element (Mn), the second coating element (Nb) and the third coating element was 6:1:0, the molar ratio of the coating agent was 4.91%, and the ternary precursor was Ni_{0.8}Co_{0.1}Mn_{0.1}(OH)₂, the doping agent was MoO₃ and NaBO₂ and the molar ratio of the doping agent was 0.5%, and the rest of the steps were the same as in example 1, the details being as shown in Table 1.

### Example 6

The composite coating agent in this example was composed of NiMnCo(OH)₂, Nb₂O₅ and ZrO₂, where the molar ratio of the first coating element (Ni, Mn, Co), the second coating element (Nb) and the third coating element (Zr) was 3:2:1, the molar ratio of the coating agent was 6.76%, and the ternary precursor was Ni_{0.8}Co_{0.1}Mn_{0.1}(OH)₂, the doping agent was ZrO₂ and Cr₂O₃ and the molar ratio of the doping agent was 0.57%, and the rest of the steps were the same as in example 1, the details being as shown in Table 1.

### Example 7

The composite coating agent in this example was composed of B(NO₃)₃ and WO₃, where the molar ratio of the first coating element (B), the second coating element (W) and the third coating element was 6:1:0, the molar ratio of the coating agent was 0.19%, and the ternary precursor was Ni_{0.9}Co_{0.05}Mn_{0.05}(OH)₂, the doping agent was MoO₃, NaBO₂ and TiO and the molar ratio of the doping agent was 0.6%, and the rest of the steps were the same as in example 1, the details being as shown in Table 1.

### Example 8

The composition of the composite coating agent in this example was Mn(OH)₂: Al₂O₃: Sr(OH)₂, where the molar ratio of the first coating element (Mn), the second coating element (Al) and the third coating element (Sr) was 7:1:0.9, the molar ratio of the coating agent was 0.86%, and the ternary precursor was Ni_{0.96}Co_{0.02}Mn_{0.02}(OH)₂, the doping agent was MoO₃, Zr₂O₃, and NaBO₂ and the molar ratio of the doping agent was 0.64%, and the rest of the steps were the same as in example 1, the details being as shown in Table 1.

### Example 9

The composition of the composite coating agent in this example was MnCO₃: Al₂O₃: 0, where the molar ratio of the first coating element (Mn), the second coating element (Al) and the third coating element was 5:1.5:0, the molar ratio of the coating agent was 8.0%, and the ternary precursor was Ni_{0.9}Co_{0.05}Mn_{0.05}(OH)₂, the doping agent was Nb₂O₅ and the molar ratio of the doping agent was 0.62%, and the rest of the steps were the same as in example 1, the details being as shown in Table 1.

### Example 10

The composition of the composite coating agent in this example was NiMnCoCO₃: WO₃: TiO, where the molar ratio of the first coating element (NiMnCo), the second coating element (W) and the third coating element (Ti) was 0.4:1:1.4, the molar ratio of the coating agent was 0.8%, and the ternary precursor was Ni_{0.8}Co_{0.15}Al_{0.05}(OH)₂, the doping agent was Ti₂O₃, Sc₂O₃, and MgO and the molar ratio of the doping agent was 0.56%, and the rest of the steps were the same as in example 1, the details being as shown in Table 1.

### Comparative example 1

S1: mixing a Ni_{0.83}Co_{0.12}Mn_{0.05}(OH)₂ ternary precursor with battery-grade lithium hydroxide monohydrate at the molar ratio of lithium to metal of 1.03: 1, and adding a doping agent TiO, the molar ratio of the doping agent being 0.4%; and then raising the temperature to 300°C under oxygen atmosphere at a heating rate of 2°C·min⁻¹ and maintaining for 4h; then raising the temperature to 700°C at 2°C·min⁻¹ and maintaining for 10h; and then cooling to room temperature at 3°C·min⁻¹ to obtain a primary calcined material;
S2: coarsely crushing and finely crushing the primary calcined material to obtain a crushed material;
S3: sieving the crushed material and removing iron to obtain a high-nickel single-crystal positive electrode material.

### Comparative example 2

In this comparative example, no coating agent was contained, and the ternary precursor was Ni_{0.83}Co_{0.12}Mn_{0.05}(OH)₂, the doping agent was Sc₂O₃ and MgO and the molar ratio of the doping agent was 0.57%, and the rest of the steps were the same as those of Comparative example 1, the details being as shown in Table 1.

### Comparative example 3

In this comparative example, no coating agent was contained, and the ternary precursor was Ni_{0.83}Co_{0.12}Mn_{0.05}(OH)₂, the coating agent was MoO₃, Zr₂O₃, NaBO₂,the molar ratio of coating agent was 0.64%, and the rest of the steps were the same as those of Comparative example 1, the details being as shown in Table 1.

### Comparative example 4

In this comparative example, the coating agent was NiCoMnCO₃ and the molar ratio of the coating agent was 0.2%, the ternary precursor was Ni_{0.83}Co_{0.12}Mn_{0.05}(OH)₂ and no doping agent was contained, and the rest of the steps are the same as in example 1, the details being as shown in Table 1.

### Comparative example 5

The composite coating agent in this comparative example was composed of MnCO₃ and MgO, where the molar ratio of the first coating element (Mn), the second coating element (Mg) and the third coating element was 1:1:0, the molar ratio of the coating agent was 0.4%, the ternary precursor was Ni_{0.83}Co_{0.12}Mn_{0.05}(OH)₂ and no doping agent was contained, and the rest of the steps were the same as in example 1, the details being as shown in Table 1.

### Comparative example 6

The composite coating agent in this comparative example was composed of NiCoMnCO₃, MgO, and Sr(OH)₂, where the molar ratio of the first coating element (NiCoMn), the second coating element (Mg) and the third coating element (Sr) was 1:1:1, the molar ratio of the coating agent was 0.6%, the ternary precursor was Ni_{0.83}Co_{0.12}Mn_{0.05}(OH)₂ and no doping agent was contained, and the rest of the steps were the same as in example 1, the details being as shown in Table 1.

### Comparative example 7

The composite coating agent in this comparative example was composed of Co(OH)₂, WO₃, and TiO, where the molar ratio of the first coating element (Co), the second coating element (W) and the third coating element (Ti) was 0.4:20:1.4, the molar ratio of the coating agent was 6.71%, the ternary precursor was Ni_{0.83}Co_{0.12}Mn_{0.05}(OH)₂, the doping agent was Ti₂O₃, Sc₂O₃, and MgO and the molar ratio of the doping agent was 0.56%, and the rest of the steps were the same as in example 1, the details being as shown in Table 1.

### Comparative example 8

The composite coating agent in this comparative example was composed of MnCO₃, Al₂O₃, and Y₂O₃, where the molar ratio of the first coating element (Mn), the second coating element (Al) and the third coating element (Y) was 17:1:0.9, the molar ratio of the coating agent was 4.8%, the ternary precursor was Ni_{0.83}Co_{0.12}Mn_{0.05}(OH)₂, the doping agent was Sc₂O₃ and MgO and the molar ratio of the doping agent was 0.56%, and the rest of the steps were the same as in example 1, the details being as shown in Table 1.

### Comparative example 9

The composite coating agent in this comparative example was composed of Zn(OH)₂, CaO, and Ba(OH)₂, where the molar ratio of the first coating element (Zn), the second coating element (Ca) and the third coating element (Ba) was 6:1:0, the molar ratio of the coating agent was 1.6%, the ternary precursor was Ni_{0.83}Co_{0.12}Mn_{0.05}(OH)₂, the doping agent was MoO₃ and the molar ratio of the doping agent was 0.39%, and the rest of the steps were the same as in example 1, the details being as shown in Table 1.

### Comparative example 10

The composite coating agent in this comparative example was composed of H₃BO₃ and Mo(OH)₃, where the molar ratio of the first coating element (B), the second coating element (Mo) and the third coating element was 1:1:0, the molar ratio of the coating agent was 9.9%, the ternary precursor was Ni_{0.83}Co_{0.12}Mn_{0.05}(OH)₂, the doping agent was Ti₂O₃ and Sc₂O₃ and the molar ratio of the doping agent was 0.4%, and the rest of the steps were the same as in example 1, the details being as shown in Table 1.

### Comparative example 11

The composite coating agent in this comparative example was composed of CoCO₃, and MgO, where the molar ratio of the first coating element (Co), the second coating element (Mg) and the third coating element was 6:0.7:0, the molar ratio of the coating agent was 8.8%, the ternary precursor was Ni_{0.83}Co_{0.12}Mn_{0.05}(OH)₂, the doping agent was Zr₂O₃, MgO, and NaBO₂ and the molar ratio of the doping agent was 0.52%, and the rest of the steps were the same as in example 1, the details being as shown in Table 1.

### Comparative example 12

The composite coating agent in this comparative example was composed of CoOOH, Al₂O₃, and CrO₃, where the molar ratio of the first coating element (Co), the second coating element (Al) and the third coating element (Cr) was 5:0.7:0.6, the molar ratio of the coating agent was 2.66%, the ternary precursor was Ni_{0.83}Co_{0.12}Mn_{0.05}(OH)₂, the doping agent was MoO₃ and the molar ratio of the doping agent was 0.46%, and the rest of the steps were the same as in example 1, the details being as shown in Table 1.

### Comparative example 13

The composite coating agent in this comparative example was Mn(OH)₂ and Nb₂O₅, where the molar ratio of the first coating element (Mn), the second coating element (Nb) and the third coating element was 3:2:0, the molar ratio of the coating agent was 6.76%, the ternary precursor was Ni_{0.83}Co_{0.12}Mn_{0.05}(OH)₂, the doping agent was Zr₂O₃, MgO, and NaBO₂ and the molar ratio of the doping agent was 0.57%, and the rest of the steps were the same as in example 1, the details being as shown in Table 1.

### Comparative example 14

The composite coating agent in this comparative example was composed of NiMnCo(OH)₂, Nb₂O₅, and ZrO₂, where the molar ratio of the first coating element (NiMnCo), the second coating element (Nb) and the third coating element (Zr) was 1:1:0.6, the molar ratio of the coating agent was 0.19%, the ternary precursor was Ni_{0.83}Co_{0.12}Mn_{0.05}(OH)₂, the doping agent was Ti₂O₃, MgO, and Sc₂O₃ and the molar ratio of the doping agent was 0.6%, and the rest of the steps were the same as in example 1, the details being as shown in Table 1.

**Table 1 The material process records of examples 1-10 and comparative example 1-6**

| Item | Positive electrode material | Doping agent | Molar fraction of doping element in positive electrode material substrate( % ) | Coating agent composition | | | Molar ratio of coating agent | Molar ratio of coating elements ( K1:K2: K3) | Molar fraction of coating elements in the matrix of positive electrode material substrate (%) | Molar fraction of coating element contained in lithium-conta ining coating element oxide to total amount of coating element (%) | Molar ratio of respective coating elements in lithium-conta ining coating element oxide (ml:m2:m3) |
|---|---|---|---|---|---|---|---|---|---|---|---|
| | | | | First coating agent | Second coating agent | Third coatin g agent | | | | | |
| Example 1 | Li(Ni_{0.85}Co_{0.1} Mn_{0.05})O₂ | ZrO₂ | 0.39 | H₃BO₃ | Mo(OH)₃ | / | 6:1:0 | 6:1:0 | 0.70 | 52 | 33:19:0 |
| Example 2 | Li(Ni_{0.83}Co_{0.12} Mn_{0.05})O₂ | TiO | 0.4 | CoCO₃ | MgO | / | 1:1:0 | 1:1:0 | 1.6 | 51 | 46:28:0 |
| Example 3 | Li(Ni_{0.82}Co_{0.1} Mn_{0.08})O₂ | Y₂O₃ | 0.52 | CoOOH | Al₂O₃ | CrO₃ | 6:0.7:0.6 | 6:1.4:0.6 | 3.71 | 54 | 52:12:12 |
| Example 4 | Li(Ni_{0.85}Co_{0.05} Mn_{0.1})O₂ | MgO, Ta₂O₅ | 0.46 | Co(OH)₂ | MoO₃ | / | 5:0.7:0 | 5:0.7:0 | 2.66 | 63 | 36:12:0 |
| Example 5 | Li(Ni_{0.83}Co_{0.12} Mn_{0.05})O₂ | MoO₃, NaBO₂ | 0.50 | Mn(OH)₂ | Nb₂O₅ | / | 6:1:0 | 6:2:0 | 4.91 | 65.6 | 50:20:0 |
| Example 6 | Li(Ni_{0.82}Co_{0.1} Mn_{0.08})O₂ | ZrO₂, Cr₂O₃ | 0.57 | NiMnCo(O H)₂ | Nb₂O₅ | ZrO₂ | 3:2:1 | 9:4:1 | 6.76 | 63 | 63:8:2 |
| Example 7 | Li(Ni_{0.9}Co_{0.05} Mn_{0.05})O₂ | MoO₃, NaBO₂, TiO | 0.60 | B(NO₃)₃ | WO₃ | / | 6:1:0 | 6:1:0 | 0.19 | 66 | 30:21:0 |
| Example 8 | Li(Ni_{0.96}Co_{0.02} Mn_{0.02})O₂ | MoO₃, Zr₂O₃, NaBO₂ | 0.64 | Mn(OH)₂ | Al₂O₃ | Sr(OH )2 | 7:1:0.9 | 7:2:0.9 | 0.86 | 65 | 89:2:2 |
| Example 9 | Li(Ni_{0.9}Co_{0.05} Mn_{0.05})O₂ | Nb₂O₅ | 0.62 | MnCO₃ | Al₂O₃ | / | 5:1.5:0 | 5:3:0 | 8.0 | 77.5 | 40:12:0 |
| Example10 | Li(Ni_{0.83}Co_{0.12} Mn_{0.05})O₂ | Ti₂O₃, Sc₂O₃, MgO | 0.56 | NiMnCoC O₃ | WO₃ | TiO | 0.4:1:1.4 | 1.2:1:1.4 | 0.80 | 82.4 | 69:21:1 |
| Comparative example 1 | Li( Ni_{0.83}Co_{0.12} Mn_{0.05})O₂ | TiO | 0.4 | / | | | | / | / | / | / |
| Comparative example 2 | Li( Ni_{0.83}Co_{0.12} Mn_{0.05})O₂ | Sc₂O₃, MgO | 0.57 | / | | | | / | / | / | / |
| Comparative example 3 | Li( Ni_{0.83}Co_{0.12} Mn_{0.05})O₂ | MoO₃, Zr₂O₃, NaBO₂ | 0.64 | / | | | | / | / | / | / |
| Comparative example 4 | Li( Ni_{0.83}Co_{0.12} Mn_{0.05})O₂ | / | / | NiCoMnC O3 | / | / | / | / | 0.2 | 78 | / |
| Comparative example 5 | Li( Ni_{0.83}Co_{0.12} Mn_{0.05})O₂ | / | / | CoCO₃ | MgO | / | 1:1:0 | 1:1:0 | 0.4 | 69 | 56:28:0 |
| Comparative example 6 | Li( Ni_{0.83}Co_{0.12} Mn_{0.05})O₂ | / | / | NiCoMnC O₃ | MgO | Sr(OH )2 | 1:1:1 | 3:1:1 | 0.6 | 72 | 50:20:10 |
| Comparative example 7 | Li( Ni_{0.83}Co_{0.12} Mn_{0.05})O₂ | Ti₂O₃, Sc₂O₃, MgO | 0.56 | Co(OH)₂ | WO₃ | TiO | 0.4:20:1.4 | 0.4:20:1.4 | 6.71 | 59 | 69:25:1 |
| Comparative example 8 | Li( Ni_{0.83}Co_{0.12} Mn_{0.05})O₂ | Sc₂O₃, MgO | 0.56 | MnCO₃ | Al₂O₃ | Y₂O₃ | 17:1:0.9 | 17:2:1.8 | 4.8 | 67 | 89:27:6 |
| Comparative example 9 | Li( Ni_{0.83}Co_{0.12} Mn_{0.05})O₂ | TiO | 0.4 | Zn(OH)₂ | CaO | Ba(OH )2 | **6:1:0.4** | 6:1:1.1 | 1.6 | 57 | 50:20:10 |
| Comparative example 10 | Li( Ni_{0.83}Co_{0.12} Mn_{0.05})O₂ | Ti₂O₃, Sc₂O₃ | 0.4 | H₃BO₃ | Mo(OH)₃ | / | 1:1:0 | 1:1:0 | 9.9 | 78 | 69:25:0 |
| Comparative example 11 | Li( Ni_{0.83}Co_{0.12} Mn_{0.05})O₂ | Zr₂O₃, MgO, NaBO₂ | 0.52 | CoCO₃ | MgO | / | 6:0.7:0 | 6:0.7:0 | 8.8 | 55 | 80:27:0 |
| Comparative example 12 | Li( Ni_{0.83}Co_{0.12} Mn_{0.05})O₂ | Ti₂O₃, Sc₂O₃, MgO | 0.56 | NiMnCoC O₃ | WO₃ | TiO | 5:0.7:0.6 | 5:1.4:0.6 | 2.66 | 36 | 36:12:1 |
| Comparative example 13 | Li( Ni_{0.83}Co_{0.12} Mn_{0.05})O₂ | Zr₂O₃, MgO, NaBO₂ | 0.57 | Mn(OH)₂ | Nb₂O₅ | / | 3:2:0 | 3:4:0 | 6.76 | 54 | 24:28:0 |
| Comparative example 14 | Li( Ni_{0.83}Co_{0.12} Mn_{0.05})O₂ | Ti₂O₃, MgO, Sc₂O₃ | 0.60 | NiMnCo(O H)₂ | Nb₂O₅ | ZrO₂ | 1:1:0.6 | 3:2:0.6 | 0.19 | 59 | 89:77:6 |

### (1) Electrochemical performance test

Preparation of positive electrode sheet: dissolving the prepared ternary positive electrode material, SP, KS-6, and PVDF in NMP under magnetic stirring according to a mass ratio of 94.5%: 2%: 1.0%: 2.5% and stirring into a paste slurry, and then coating the obtained slurry on a 15µm thick current collector of aluminum foil with a coating machine and rolling to form, and then drying at 125°C in an oven, and cutting into a positive electrode sheet with a desired size.

Preparation of negative electrode sheet: dissolving graphite, SP, CMC and SBR in deionized water under magnetic stirring according to a mass ratio of 95.5%:1%:1.5%:2.0% and stirring into a paste slurry, and then coating the obtained slurry on a 10µm thick current collector of copper foil with a coating machine and rolling to form, drying in an oven at 115°C, and cutting into a negative electrode sheet with a desired size.

Battery assembling: coiling the positive electrode sheet, a separator PP, the negative electrode sheet into a desired battery cell, baking in an oven at 85°C for 10h, packaging with aluminum-laminated film, tab welding, performing a short-circuit test, and then continuing to bake for 20h until the test of moisture is qualified, injecting with electrolyte, exhausting gas, sealing, pre-charging, performing formation, aging and other processes to get the desired battery.

**Table 2 Material capacity and cycling data test results for examples 1-10 and comparative examples 1-6**

| Item | Capacity / mAh·g⁻¹(95% SOC) | Cycles/times (95% SOC) |
|---|---|---|
| Example 1 | 200 | 542 |
| Example 2 | 196 | 560 |
| Example 3 | 194 | 501 |
| Example 4 | 201 | 578 |
| Example 5 | 195.5 | 572 |
| Example 6 | 197 | 560 |
| Example 7 | 214 | 396 |
| Example 8 | 225 | 359 |
| Example 9 | 212 | 436 |
| Example 10 | 196 | 469 |
| Comparative example 1 | 155 | 332 |
| Comparative example 2 | 156 | 307 |
| Comparative example 3 | 154 | 314 |
| Comparative example 4 | 155 | 332 |
| Comparative example 5 | 156 | 345 |
| Comparative example 6 | 157 | 362 |
| Comparative example 7 | 150 | 365 |
| Comparative example 8 | 154 | 377 |
| Comparative example 9 | 155 | 307 |
| Comparative example 10 | 154 | 316 |
| Comparative example 11 | 155 | 331 |
| Comparative example 12 | 155 | 342 |
| Comparative example 13 | 151 | 361 |
| Comparative example 14 | 154 | 373 |

Note: 95% SOC means that the capacity of the battery after a certain number of cycles is 95% of the initial capacity.

### (2) Residual alkali test

The residual alkali content of the samples of examples 1-10 and comparative examples 1-6 are tested, and the test is specifically carried out by potentiometric titration, and the test results are shown in Table 3.

**Table 3 Test results of residual alkali and gas production data of materials of examples 1-10 and comparative examples 1-6**

| Item | Li₂CO₃ (ppm) | LiOH (ppm) | Free Li⁺ (ppm) | Gas production rate (%) |
|---|---|---|---|---|
| Example 1 | 563 | 1311 | 1013 | 3.7 |
| Example 2 | 612 | 1412 | 1025 | 2.9 |
| Example 3 | 653 | 1693 | 1099 | 3.3 |
| Example 4 | 669 | 1332 | 1236 | 3.7 |
| Example 5 | 708 | 1167 | 1073 | 3.2 |
| Example 6 | 659 | 1490 | 1365 | 2.8 |
| Example 7 | 783 | 1159 | 1346 | 2.7 |
| Example 8 | 814 | 1446 | 1265 | 2.8 |
| Example 9 | 801 | 1163 | 1314 | 2.7 |
| Example 10 | 789 | 1237 | 1306 | 2.9 |
| Comparative example 1 | 3708 | 4255 | 1207 | 12.9 |
| Comparative example 2 | 3692 | 3975 | 2527 | 13.4 |
| Comparative example 3 | 3589 | 4163 | 2525 | 15.6 |
| Comparative example 4 | 3409 | 4326 | 2507 | 16.7 |
| Comparative example 5 | 3306 | 4216 | 2499 | 15.1 |
| Comparative example 6 | 3512 | 4679 | 2546 | 14.8 |
| Comparative example 7 | 3782 | 4408 | 2300 | 16.7 |
| Comparative example 8 | 3901 | 4358 | 2455 | 15.2 |
| Comparative example 9 | 3691 | 3975 | 2527 | 13.1 |
| Comparative example 10 | 3587 | 4153 | 2521 | 15.7 |
| Comparative example 11 | 3402 | 4318 | 2515 | 16.9 |
| Comparative example 12 | 3301 | 4116 | 2485 | 15.8 |
| Comparative example 13 | 3780 | 4378 | 2311 | 17.2 |
| Comparative example 14 | 3900 | 4343 | 2442 | 15.8 |

It can be seen from the table that the material obtained by dry coating the composite coating agent used in the present invention achieves improved capacity and cycle stability and has low surface residual alkali.

Referring to the data of comparative examples 1-3, it can be seen that when the positive electrode material substrate is not coated, the stability of the corresponding battery is significantly reduced, where the capacity and cycle performance of comparative examples 1-3 are each lower than those of examples 1-10, and the surface residual alkali contents and gas production rates of comparative examples 1-3 are each higher than those of examples 1-10.

Referring to the data of comparative examples 4-6, it can be seen that when the positive electrode material substrate is undoped, the stability of the corresponding battery is significantly reduced, where the capacity and cycle performance of comparative examples 4-6 are each lower than those of examples 1-10, and the surface residual alkali contents and gas production rates of comparative examples 4-6 are each higher than those of examples 1-10.

Referring to the data of comparative examples 7-8, it can be seen that when the ratio of the coating element is not within the range set in the present application, the stability of the corresponding battery is significantly reduced, where the capacity and cycle performance of comparative examples 7-8 are each lower than those of examples 1-10, and the surface residual alkali contents and gas production rates of comparative examples 7-8 are each higher than those of examples 1-10.

Referring to the data of comparative example 9, it can be seen that when the material of the present invention is doped and the doping ratio is within the scope of the present invention and the coating agent is not within the scope of the present invention, the stability of the corresponding battery decreases, where the capacity and cycle performance of comparative example 9 are lower than those of examples 1-10, and the surface residual alkali and gas production rate of comparative example 9 are higher than those of examples 1-10.

Referring to the data of comparative examples 10-11, it can be seen that when doping and coating are within the scope of the present invention, if the molar fraction of the coating element in the positive electrode material substrate is excessive, the stability of the corresponding battery will also decrease, where the capacity and cycle performance of comparative examples 10-11 are lower than those of examples 1-10, and the surface residual alkali content and gas production rate of comparative examples 10-11 are higher than those of examples 1-10.

Referring to the data of comparative example 12, it can be seen that when the material of the present invention is doped and the doping ratio is within the scope of the present invention and the ratio of the coating agent is also within the scope of the present invention, if the molar fraction of the coating element contained in the lithium-containing coating element oxide to the total amount of the coating element is lower than the scope of the present invention, the stability of the corresponding battery will also decrease, where the capacity and cycle performance of comparative example 12 are lower than those of examples 1-10, and the surface residual alkali content and gas production rate of comparative example 12 are higher than those of examples 1-10.

Referring to the data of comparative examples 13-14, it can be seen that when doping and coating are both within the scope of the present invention, if the molar ratio of each coating element in the lithium-containing coating element oxide is not within the scope of the present invention, the stability of the corresponding battery will also decrease, where the capacity and cycle performance of comparative examples 13-14 are lower than those of examples 1-10, and the surface residual alkali content and gas production rate of comparative examples 13-14 are higher than those of examples 1-10.

Based on the results of the above examples and comparative examples, within the range of doping and coating materials of the present invention, if the corresponding ratio also conforms to the present invention, the residual alkali content and gas production rate of the positive electrode material are greatly reduced, the capacity is slightly improved, and the cycle life is also improved. Therefore, the doping agent and the coating agent within a certain range in the present invention have an effect of reducing the amount of alkali on the surface of the material, and improving the life and capacity of the positive electrode material.

The above description is only a preferred embodiment of the present invention, and it should be noted that for a person skilled in the art, many improvements and modifications may also be made without departing from the principles of the present invention, and these improvements and modifications should also be considered to be within the scope of protection of the present invention.

## Claims

1. A composite coating agent for a positive electrode material, comprising a first coating agent, a second coating agent, and a third coating agent; the first coating agent being a hydroxide, an oxide, a sulfide, a nitrate, or a carbonate of a first coating element; the second coating agent being a hydroxide, an oxide, a sulfide, a nitrate, or a carbonate of a second coating element; the third coating agent being a hydroxide, an oxide, a sulfide, a nitrate, or a carbonate of a third coating element;
wherein the first coating element comprises one or more of Ni, Mn, Co, and B; the second coating element comprises one or more of Mg, Al, Nb, W, and Mo; the third coating element comprises one or more of Ti, Cr, Zr, Y, and Sr.

2. The coating agent according to claim 1, wherein a molar ratio of the first coating element, the second coating element, and the third coating element is 1-15: 0.1-18: 0-12.

3. The coating agent according to claim 1, wherein the first coating agent is at least one of NiMnCo(OH)₂, NiMnCoCO₃, Co(OH)₂, MnCO₃, CoCO₃, H₃BO₃, B(NO₃)₃, CoOOH, or Mn(OH)₂;
the second coating agent is at least one of MgO, MgCO₃, Mg(OH)₂, Al₂O₃, Al(OH)₃, MoO₃, Mo(OH)₃, WO₃, Nb(OH)₅, or Nb₂O₅;
the third coating agent is at least one of TiO, Cr(OH)₂, ZrO₂, C₂O₅Zr, Y₂O₃, and Sr(OH)₂.

4. A coating layer prepared from the coating agent according to any one of claims 1-3.

5. A high-nickel single-crystal positive electrode material, comprising a positive electrode material substrate and the coating layer according to claim 4 disposed on a surface of the positive electrode material substrate.

6. The high-nickel single-crystal positive electrode material according to claim 5, wherein a structural formula of the positive electrode material substrate is LiₓNiₐM_{b}N_{c}O₂, and wherein 0.8 ≤ x ≤ 1. 05, 0.8 ≤ a ≤ 0. 98, b = 1-a-c, and 0 ≤ c < 0.2; M is selected from at least one of Mn, Co, Al, Mg, or Fe; N is a doping element selected from at least one of Ti, Ta, K, Sb, Na, B, Sc, V, Sn, Y, Zr, Mg, Cr, Nb, W, or Mo.

7. The high-nickel single-crystal positive electrode material according to claim 5, wherein a molar fraction of the coating element in the coating layer to the positive electrode material substrate is 0.0001-8%.

8. The high-nickel single-crystal positive electrode material according to claim 5, wherein the coating layer is composed of a lithium-containing coating element oxide and a lithium-free coating element oxide.

9. The high-nickel single-crystal positive electrode material according to claim 8, wherein a ratio of a molar amount of a coating element contained in the lithium-containing coating element oxide to a total amount of the coating element is 50%-89%.

10. The high-nickel single-crystal positive electrode material according to claim 8, wherein a molar ratio of the first coating element, the second coating element, and the third coating element in the lithium-containing coating element oxide is 29-100: 0-71: 0-66.

11. A preparing method of a high-nickel single-crystal positive electrode material, comprising the following steps:
A) mixing a ternary precursor and lithium hydroxide monohydrate, adding a doping agent, and calcining in the presence of a protective gas to obtain a calcined material;
B) crushing the calcined material, removing iron and sieving to obtain a positive electrode material substrate;
C) mixing the positive electrode material substrate with a coating agent, calcining again in the presence of the protective gas, then crushing, sieving and removing iron to obtain the high-nickel single-crystal positive electrode material.

12. The preparing method of a high-nickel single-crystal positive electrode material according to claim 11, wherein the doping agent is selected from at least one of TiO, Ti₂O₃, Sc₂O₃, MgO, K₂CO₃, V₂O₅, Cr₂O₃, Sb₂O₃, Ta₂O₅, Y₂O₃, ZrO₂, Zr₂O₃, NaBO₂, WO₃, MoO₃, Nb₂O₅, and the like;
the calcining in the step A) specifically comprises: raising a temperature to 190-420°C at a heating rate of 1-10°C·min⁻¹ and maintaining for 3.5-10.5h; then raising the temperature to 690-920°C at 2-4°C·min⁻¹ and maintaining for 8-11h; and then cooling to room temperature at 2-3°C·min⁻¹;
the calcining in the step C) specifically comprises: raising a temperature to 500-810°C at a heating rate of 3-10°C/min and maintaining for 9-11h.

13. A lithium-ion battery, comprising the high-nickel single-crystal positive electrode material according to any one of claims 5-10 or a high-nickel single-crystal positive electrode material prepared by the preparing method according to any one of claims 11-12.
